# FASCICULE DE BREVET EUROPEEN

(11) **EP 4 738 408 B1**
(45) Date de publication et mention de la délivrance du brevet: **25.11.2026**
(21) Numéro de dépôt: 25210728.9
(22) Date de dépôt: 23.10.2025
(51) Int. Cl.: H01H 3/16, G01R 22/06

(54) **DISPOSITIF À DÉTECTION D'OUVERTURE**
ÖFFNUNGSDETEKTIONSVORRICHTUNG
DEVICE WITH APERTURE DETECTION

(30) Priorité: 04.11.2024 FR 2412057
(43) Date de publication de la demande: 06.05.2026
(73) Titulaire: SAGEMCOM ENERGY & TELECOM SAS, 92270 Bois-Colombes (FR)
(72) Inventeur: TEBOULLE, Henri, 92270 Bois-Colombes (FR); GRINCOURT, Christophe, 92270 Bois-Colombes (FR)
(74) Mandataire: Novagraaf Technologies

(56) Documents cités:
- WO-A1-2011/113519
- CH-A1- 713 130
- FR-A1- 3 133 927
- US-A1- 2014 125 316
- DESAI AVINASH R ET AL: "Anti-counterfeit Integrated Circuits using fuse and tamper-resistant time-stamp circuitry", 2013 IEEE INTERNATIONAL CONFERENCE ON TECHNOLOGIES FOR HOMELAND SECURITY (HST), IEEE, 12 November 2013 (2013-11-12), pages 480 - 485, XP032550114, DOI: 10.1109/THS.2013.6699051

## Description

### DOMAINE TECHNIQUE

Les différents exemples de réalisation décrits dans la présente divulgation concernent un dispositif muni d'une détection d'ouverture. Le dispositif peut notamment être, mais de façon non limitative, un compteur électrique.

### TECHNIQUE ANTERIEURE

Les compteurs de consommables tels les compteurs d'électricité sont susceptibles d'être manipulés dans le cadre de fraudes. La détection de l'ouverture du compteur, une fois installé en son lieu d'utilisation et sa mise en service effectuée, est un élément pouvant indiquer qu'une fraude a été commise - cette détection peut donner lieu à l'intervention de l'opérateur concerné pour vérification.

Certains compteurs connus proposent une fonction de détection d'ouverture de couvre-borne et/ou de capot, en particulier à l'aide d'une pile qui continue à alimenter un microcontrôleur lorsque le compteur n'est plus sous tension. Le microcontrôleur peut alors surveiller en permanence l'état d'un interrupteur lié au capot ou au couvre-bornes. La pile peut également être remplacée par une super-capacité de forte valeur, typiquement 1F, ce qui permet de maintenir la fonction de détection active pendant cinq à sept jours. Les composants sont cependant onéreux et certains opérateurs proscrivent la présence d'une pile dans un compteur. De plus, la durée de la détection est nécessairement limitée dans le temps - il est ainsi possible de détacher le capot ou le couvre-bornes sans risque de détection simplement en attendant assez longtemps.

Il est connu par ailleurs d'utiliser un relais monostable comportant un noyau mobile pour la détection de l'ouverture d'un capot fermant un caisson de compteur. Il est également connu d'utiliser une roue codeuse réagissant à l'ouverture du capot. Cependant, de telles solutions sont onéreuses et peuvent être mécaniquement complexes et notamment, comme par exemple pour la roue codeuse, être sujettes à des incertitudes mécaniques. Pour cette dernière solution, l'ouverture ne peut plus être détectée si l'on revient à la valeur initiale.

Une solution simple permettant la détection de l'ouverture d'un boîtier de compteur, même hors tension est souhaitable.

Le document FR3133927A1 décrit un dispositif comportant : un boîtier comportant des composants ; un cache configuré pour être positionné sur le boîtier pour limiter l'accès aux composants lorsque le cache est en position fermée ; un circuit de charge d'un condensateur configuré pour charger le condensateur lorsque le dispositif est sous tension ; un circuit de décharge du condensateur, ledit circuit de décharge comportant un premier interrupteur coopérant avec une pièce solidaire du cache pour bloquer la décharge du condensateur lorsque le cache est en position fermée ; et permettre la décharge du condensateur lorsque le cache est en position ouverte.

### RESUME DE l'INVENTION

Un premier aspect concerne un dispositif comportant :
un boîtier comportant des composants; un cache configuré pour être positionné sur le boîtier pour limiter l'accès aux composants lorsque le cache est en position fermée ; un condensateur et un fusible, le condensateur et le fusible étant dimensionnés pour que le fusible claque lorsque le condensateur se décharge à travers le fusible ; un circuit de charge du condensateur configuré pour charger le condensateur lorsque le dispositif est sous tension ; un circuit de décharge du condensateur à travers le fusible, ledit circuit de décharge comportant un premier interrupteur coopérant avec une pièce solidaire du cache pour bloquer la décharge du condensateur lorsque le cache est en position fermée; et permettant la décharge du condensateur à travers le fusible lorsque le cache est en position ouverte.

Ainsi, après une installation et une première mise sous tension du dispositif, le cache ne peut plus être ouvert sans que cela ne soit détecté, même quand le dispositif n'est plus sous tension, c'est-à-dire n'est plus relié à une source d'énergie externe. L'énergie stockée par le condensateur n'est utilisée que pour le cas échéant créer un courant dans le fusible. Ceci permet de maintenir la fonctionnalité de détection active pendant une durée longue.

Selon un ou plusieurs exemples de réalisation, le circuit de décharge est configuré pour relier électriquement le condensateur et le fusible à travers le premier interrupteur, le premier interrupteur comprenant des pièces conductrices configurées pour être en contact électrique lorsque le cache est en position ouverte et pour être écartées par la pièce solidaire du cache lorsque le cache est en position fermée, interrompant ainsi le contact électrique entre les pièces conductrices.

Selon un ou plusieurs exemples de réalisation, les pièces conductrices comportent deux lamelles métalliques.

Selon un ou plusieurs exemples de réalisation, la pièce solidaire du cache est un membre proéminent solidaire du cache.

Il est possible d'augmenter la sécurité du dispositif en plaçant ou protégeant l'interrupteur et le fusible de façon à éviter ou du moins fortement limiter les possibilités de manipulation par une personne non-autorisée, mais qui connaitrait intimement le fonctionnement de la détection d'ouverture.

Par exemple, l'interrupteur et le fusible peuvent être placés dans un compartiment du boîtier isolé par une paroi de la partie du boîtier rendue accessible par l'ouverture du cache. L'interrupteur est cependant disposé de façon à pouvoir interagir avec le membre proéminent du cache, par exemple par l'entremise d'une ouverture pratiquée dans une paroi.

Avantageusement, les dimensions de l'ouverture sont proches de celles de la section du membre proéminent. Ainsi, un tiers mal intentionné ne peut pas atteindre l'interrupteur avant d'enlever le cache et n'a pas le temps d'interdire la décharge du condensateur qui va claquer le fusible lorsque l'on retire le cache.

L'un ou l'autre de ces composants (interrupteur et fusible) peut aussi être placé sous une protection discrète adéquate. L'implémentation particulière sur un circuit imprimé peut aussi limiter la manipulation. Par ailleurs, ces deux composants peuvent être choisis pour que leur structure propre limite leur manipulation, et selon le composant, l'accès à ses bornes, son enlèvement ou remplacement.

Selon un ou plusieurs exemples de réalisation, le circuit de charge comporte une source de tension reliée à une première borne du condensateur à travers une résistance, une seconde borne du condensateur étant reliée à la masse, la source de tension étant configurée pour fournir une tension de charge du condensateur lorsque le dispositif est sous tension.

Selon un ou plusieurs exemples de réalisation, le condensateur est dans un état déchargé avant une première mise sous tension du dispositif.

Selon un ou plusieurs exemples de réalisation, le dispositif comporte un second interrupteur commandé par un signal de commande, le second interrupteur étant configuré pour permettre le déchargement du condensateur autrement qu'en passant par le fusible.

Selon un ou plusieurs exemples de réalisation, le second interrupteur est configuré pour court-circuiter le condensateur en réponse au signal de commande.

Selon un ou plusieurs exemples de réalisation, le dispositif comporte un processeur configuré pour générer le signal de commande sous contrôle d'un utilisateur autorisé.

Selon un ou plusieurs exemples de réalisation, le dispositif est un compteur électrique et les composants comprennent les bornes électriques du compteur.

Selon un ou plusieurs exemples de réalisation, le dispositif comporte un processeur configuré pour déterminer si le fusible a claqué ou non et dans l'affirmative, générer un signal d'alerte.

Selon un exemple de réalisation, le fusible est un fusible sérigraphié sur un circuit imprimé du dispositif. On limite ainsi la possibilité d'un remplacement d'un fusible claqué par une personne non-autorisée.

### BREVE DESCRIPTION DES FIGURES

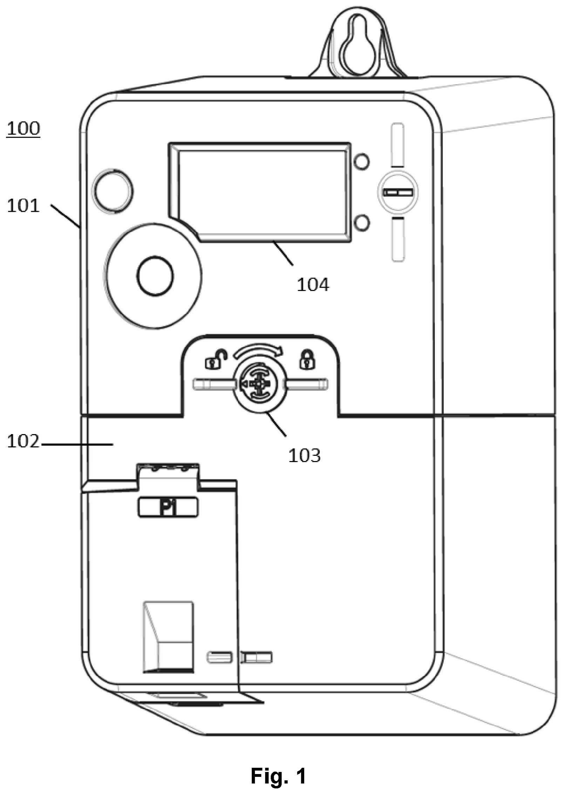

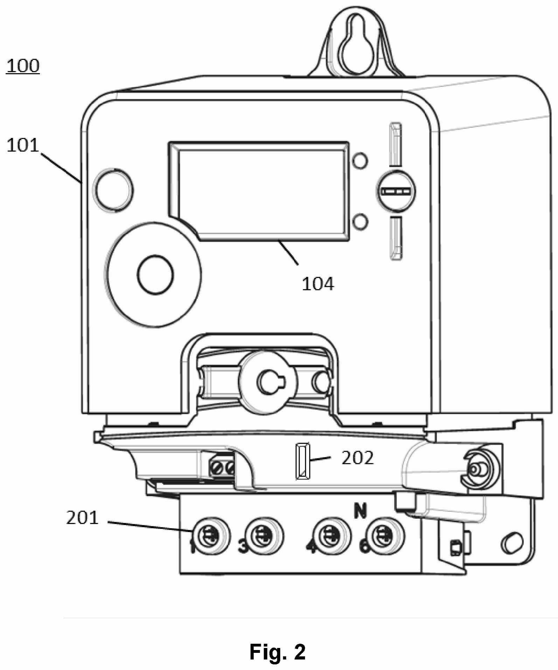

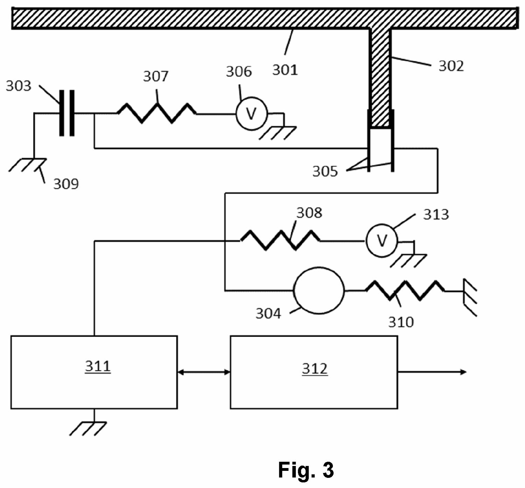

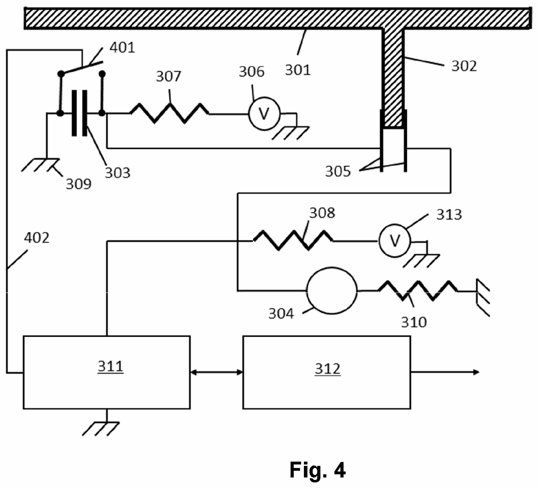

Les exemples de réalisation seront mieux compris à la lumière de la description détaillée qui va suivre et des dessins qui l'accompagnent, lesquels sont donnés à titre d'illustration uniquement et ne sont donc pas limitatifs de la présente divulgation.
La figure FIG.1 est un diagramme de dispositif comprenant un capot amovible recouvrant les bornes du compteur, selon un mode de réalisation.
La figure FIG.2 est un diagramme du dispositif de la figure 1, le capot ayant été enlevé.
La figure FIG.3 est un schéma d'un premier exemple de réalisation.
La figure FIG.4 est un schéma d'un second exemple de réalisation.

### DESCRIPTION DETAILLEE

Divers exemples de réalisation vont maintenant être décrits plus en détail, à titre d'exemples non limitatifs, en référence aux dessins qui accompagnent la présente divulgation et qui illustrent certains exemples de réalisation.

Les détails structurels et fonctionnels spécifiques décrits ici constituent des exemples non limitatifs. Les exemples de réalisation décrits ici peuvent faire l'objet de diverses modifications et formes alternatives. L'objet de la divulgation peut être réalisé sous de nombreuses formes différentes et ne doit pas être interprété comme étant limité aux seules réalisations présentées ici à titre d'exemples illustratifs. Il convient de comprendre qu'il n'y a aucune intention de limiter les modes de réalisation aux formes particulières décrites dans la suite de ce document.

Dans la description qui va suivre, des éléments identiques, similaires ou analogues seront désignés par les mêmes chiffres de référence. Les diagrammes blocs, algorigrammes et diagrammes de séquence de messages dans les figures illustrent l'architecture, les fonctionnalités et le fonctionnement de systèmes, dispositifs, procédés et produits programmes d'ordinateur selon un ou plusieurs exemples de réalisation. Chaque bloc d'un diagramme bloc ou chaque phase d'un algorigramme peut représenter un module ou encore une portion de code logiciel comprenant des instructions pour l'implémentation d'une ou plusieurs fonctions. Selon certaines implémentations, l'ordre des blocs ou des phases peut être changé, ou encore les fonctions correspondantes peuvent être mises en œuvre en parallèle. Les blocs ou phases de procédé peuvent être implémentés à l'aide de circuits, de logiciels ou d'une combinaison de circuits et de logiciels, et ce de façon centralisée, ou de façon distribuée, pour tout ou partie des blocs ou phases. Les systèmes, dispositifs, procédés et méthodes décrits peuvent être modifiés, faire l'objet d'ajouts et/ou de suppressions tout en restant dans le cadre de la présente description. Par exemple, les composants d'un dispositif ou d'un système peuvent être intégrés ou séparés. Également, les fonctions décrites peuvent être mises en œuvre à l'aide de plus ou de moins de composants ou de phases, ou encore avec d'autres composants ou à travers d'autres phases. Tout système de traitement de données adapté peut être utilisé pour l'implémentation. Un système ou dispositif de traitement de données adapté comprend par exemple une combinaison de code logiciel et de circuits, tels un processeur, contrôleur ou autre circuit adapté pour exécuter le code logiciel. Lorsque le code logiciel est exécuté, le processeur ou contrôleur conduit le système ou dispositif à mettre en œuvre tout ou partie des fonctionnalités des blocs et/ou des phases des procédés ou méthodes selon les exemples de réalisation. Le code logiciel peut être stocké dans une mémoire non volatile ou sur un support de stockage non volatile (clé USB, carte mémoire ou autre support) lisible directement ou à travers une interface adaptée par le processeur ou contrôleur.

La présente divulgation s'applique à tout dispositif à boîtier comportant un ou plusieurs composants disposés derrière un cache.

Par 'cache', on comprend toute pièce destinée à donner accès à certains composants du dispositif lorsque le cache est enlevé et à interdire cet accès lorsqu'il est en position sur le boîtier. Dans le cas d'un compteur électrique, il peut s'agir - par exemple - du capot du compteur, mais aussi d'un couvre-bornes.

Il est à noter que les exemples de réalisation ne sont pas limitatifs. En particulier, d'autres composants que ceux illustrés peuvent être utilisés pour implémenter les fonctions décrites, et moins de composants ou des composants supplémentaires peuvent bien entendu être mis en œuvre. Par ailleurs, les différentes valeurs données le sont pour la clarté de l'explication et peuvent également différer.

La FIG.1 est un exemple non-limitatif d'un dispositif 100, en l'occurrence un compteur électrique. Le dispositif illustré comporte un boîtier 101 et un cache 102 venant se positionner sur le boîtier pour empêcher l'accès aux bornes électriques du compteur. Dans exemple représenté, le cache 102 se verrouille mécaniquement sur le boîtier 100 à l'aide d'un mécanisme de verrouillage 103. Le dispositif illustré comporte d'autres composants, tels par exemple un écran d'affichage 104. L'écran peut être un écran tactile configuré pour implémenter une interface homme-machine.

La FIG. 2 montre le dispositif de la FIG. 1 sans le cache 102. La FIG. 2 montre ainsi des bornes électriques 201 du compteur (phases et neutres), qui ne sont pas accessibles lorsque le cache est en place sur le compteur, que cela soit pour des raisons de sécurité ou de limitation de fraude.

Selon un ou plusieurs exemples de réalisation, le dispositif comprend un circuit de détection d'ouverture du cache. Le principe sous-tendant les différents modes de réalisation est qu'un condensateur est chargé lorsque le dispositif est sous tension. La décharge de ce condensateur est déclenchée en fermant un circuit de décharge lorsque le cache est ouvert. La décharge est effectuée à travers un fusible. Le condensateur et le fusible sont prévus pour que le fusible claque lors de cette décharge.

Selon un mode de réalisation, la charge du condensateur est typiquement effectuée après la première mise sous tension du dispositif, suite à son installation dans son lieu de fonctionnement, puisque c'est - généralement - à partir de l'installation que l'on cherchera à détecter une éventuelle fraude.

Selon un mode de réalisation, la fermeture du circuit de décharge peut être effectuée à l'aide d'un interrupteur maintenu ouvert par une partie du cache lorsque ce dernier est en position fermée sur le boîtier pour empêcher l'accès aux composants, l'interrupteur étant configuré pour se fermer lorsque le cache n'est plus en position fermée sur le boîtier.

L'état - conducteur ou non conducteur - du fusible est facilement détectable et peut donner lieu à un avertissement au moment opportun.

Selon un mode de réalisation, l'état du fusible est déterminé par un processeur à partir de la tension à une borne du fusible.

Le condensateur ne sert pas à alimenter un circuit actif qui consommerait l'énergie stockée. Ceci permet d'utiliser un condensateur avec une capacité relativement faible (par exemple 10µF), et donc peu onéreuse, et de maintenir sa charge pendant une durée très longue.

L'interrupteur et le fusible sont placés de façon à restreindre les possibilités de manipulation par une personne non-autorisée. Il s'agit par exemple d'empêcher une tentative de maintenir l'interrupteur ouvert ou de court-circuiter (ou le cas échéant de remplacer) le fusible. Par exemple, l'interrupteur et le fusible peuvent être placés sur un circuit imprimé localisé dans un compartiment fermé du boîtier 101 et séparé de la partie de ce boîtier accessible lorsque le cache est ouvert par des parois appropriées, une ouverture étant pratiquée dans une paroi du compartiment pour permettre à un membre proéminent du cache d'atteindre l'interrupteur lorsque le cache est fermé.

La figure 3 est un diagramme d'un premier exemple de réalisation d'un circuit de détection de l'ouverture du cache.

Dans l'exemple illustré, le cache porte la référence 301. Lorsque le cache est en position fermée sur le boîtier, le cache vient interrompre la continuité d'un circuit configuré pour décharger une capacité 303 à travers un fusible 304.

Selon un mode de réalisation, une implémentation possible consiste à prévoir que le cache comporte un membre proéminent 302, par exemple un picot, qui vient écarter deux lamelles métalliques élastiques 305 lorsque le cache est en position fermée sur le boîtier. Le picot est formé dans un matériau non conducteur, par exemple la même matière isolante que le cache. Les lamelles et le membre proéminent forment ainsi un interrupteur. Les lamelles sont configurées pour faire contact électrique en l'absence du membre proéminent. Elles relient une première borne du condensateur 303 (en l'occurrence la borne positive) et une première borne du fusible 304. Lorsque la continuité électrique entre les lamelles est rétablie, le condensateur, s'il est chargé, se décharge à travers le fusible. D'autres réalisations de l'interrupteur peuvent être envisagées, du moment que l'interrupteur est ouvert lorsque le cache est en position fermée sur le boîtier et fermé lorsque le cache est ouvert.

Selon un mode de réalisation, le circuit de charge du condensateur comprend une source de tension 306 connectée à la première borne du condensateur à travers une résistance 307. La seconde borne (négative) du condensateur 303 est connectée à la masse 309. La source de tension 306 n'est active que lorsque le dispositif 100 est sous tension. Le dispositif est en principe mis sous tension après son installation et une fois le cache fermé. C'est alors que le condensateur se charge. La valeur de la résistance 307 est choisie pour limiter le courant de charge du condensateur 303. Un exemple de valeur de cette résistance 307 est par exemple 100kΩ. La source de tension 306 est par exemple à une tension de 3.3V.

Selon l'exemple de réalisation de la figure 3, l'état (conducteur ou non-conducteur) du fusible est déterminé par un processeur, par exemple le microcontrôleur 311, à partir de la tension à la première borne du fusible.

Selon une implémentation possible, une résistance 308 est connectée d'une part à une source de tension 313 et d'autre part à la première borne du fusible. La seconde borne du fusible est reliée à la masse à travers une résistance 310. La résistance 310 est destinée à forcer la première borne du fusible à une tension nulle lorsque le fusible conduit. Lorsque le fusible ne conduit plus, la tension à la première borne du fusible est déterminée par la source de tension 313. La valeur de la résistance 308 est choisie très grande pour réduire le courant pouvant circuler de la source 313 à la masse à travers le fusible puis la résistance 310 lorsque le fusible conduit. La valeur de la résistance 310 est choisie faible notamment pour permettre le claquage du fusible quand le condensateur se décharge. La résistance 308 a par exemple une valeur de 100kΩ et la résistance 310 a par exemple une valeur de 10Ω. Le ratio important entre les deux résistances 308 et 310 permet de polariser la première borne du fusible à la masse lorsque le fusible conduit. La source de tension 313 est par exemple à une tension de 3.3V.

Le condensateur 303 est par exemple un condensateur multicouche de 10µF ± 20% / 10V.

Le fusible 304 est par exemple un fusible sérigraphié dimensionné pour claquer avec certitude à 330mA et à ne pas claquer avec certitude à 33µA. Pour s'assurer du claquage lors de la décharge du condensateur, on peut par exemple choisir un seuil de claquage de 200mA < 1ms. On peut prévoir une piste spécifique en cuivre de 10mm de longueur minimum, d'épaisseur de 35µm et d'une largeur de 100µm. Un autre exemple de fusible est un fusible ultra rapide (de type 'FF') dimensionné pour claquer à 200mA < 1ms. D'autres types de fusible peuvent être envisagés par la personne du métier.

Selon l'exemple de la figure 3, le dispositif comporte en outre optionnellement une interface de communication 312. Ce modem est par exemple et de façon non limitative, un modem CPL, ou un modem RF, ou une interface sans fil de type 'Wi-Fi' ou encore une interface de réseau cellulaire.

Selon un exemple de réalisation, le fonctionnement du dispositif de la figure 3 peut comprendre les étapes suivantes:
a) En sortie d'usine, le condensateur 303 est à l'état déchargé. Par exemple, les lamelles 305 sont en contact, le cache 301 n'étant pas monté. Le ratio important entre les résistances 307 et 310 a pour effet que le niveau de charge du condensateur 303 est négligeable et pratiquement égal à 0V.
b) Le condensateur 307 sera chargé à la première mise sous tension, après installation et fermeture du cache (en l'occurrence la fermeture du capot ou du couvre-bornes). Le membre solidaire du cache s'insère entre les deux lamelles, qui ne sont alors plus en contact.
c) La première borne du fusible, qui est conducteur à ce stade, est polarisée au niveau bas (tension nulle), étant donné le ratio important entre les résistances 308 et 310. Le processeur 311 détecte le niveau bas et constate que le cache n'a pas été ouvert.
d) Lorsque le cache est ouvert, le condensateur se décharge à travers le fusible.
e) Le fusible claque et devient non-conducteur. La tension à la première borne du fusible est alors au niveau haut (par l'intermédiaire de la source de tension 313).
f) Le processeur 311 détecte le niveau haut et par conséquent l'ouverture du cache.
g) Le processeur 311 peut déclencher une ou plusieurs actions suite à la détection de l'ouverture du cache.

En principe, le dispositif aura été mis hors tension avant l'ouverture du cache. Le processeur 311 n'est alors plus alimenté. Lorsque le dispositif est de nouveau sous tension, le processeur 311 peut détecter que le cache a été ouvert, même s'il a été refermé depuis.

Selon un mode de réalisation, en cas de détection d'une ouverture du cache par le processeur, une ou plusieurs des actions suivantes sont déclenchées :
- La transmission d'un message d'alerte par l'intermédiaire de l'interface de communication 312. Par exemple, la transmission peut être effectuée vers l'opérateur du réseau électrique.
- L'ouverture de l'organe de coupure du compteur de manière à arrêter toute alimentation de l'abonné via le compteur.

De préférence, les moyens d'interruption et le membre solidaire du cache sont configurés pour qu'il ne soit pas possible d'accéder aux moyens d'interruption en cas d'enlèvement du cache avant que les moyens d'interruption n'aient déclenché le déchargement du condensateur.

Selon un exemple de réalisation non limitatif, ceci peut par exemple être obtenu en plaçant les moyens d'interruption derrière une ouverte ou un couloir pratiqué dans une paroi interne du boîtier, comme illustré à la FIG. 2 (référence 202), et dans lequel vient se positionner le membre solidaire du cache de façon à ce que le membre solidaire bloque toujours l'accès à cette ouverture lorsque le cache est en cours de retrait, alors même que le membre aura déjà été suffisamment déplacé pour déclencher la décharge du condensateur. Selon un autre exemple de réalisation non limitatif, il est également possible de simplement placer les moyens d'interruption proches de la paroi interne du cache. Selon un autre exemple de réalisation combinable avec ce qui précède, les moyens d'interruption et le membre solidaire sont agencés pour que même un retrait très court du cache déclenche la décharge du condensateur.

Selon une variante de réalisation, le dispositif comporte un circuit de décharge additionnel du condensateur 303. Le circuit de décharge additionnel a pour but de permettre la décharge du condensateur sans que cette décharge ne s'effectue à travers le fusible. Ceci permet ensuite d'ouvrir le cache sans que le fusible ne claque, par exemple pour permettre des opérations de maintenance.

Un exemple d'implémentation non limitatif de cette variante est de prévoir un interrupteur contrôlable pour court-circuiter le condensateur 303.

La FIG. 4 reprend les éléments de la FIG. 3, et comporte de plus un interrupteur 401 venant connecter les deux bornes du condensateur 303 lorsqu'il est fermé. Dans l'exemple présenté, l'interrupteur est commandé par un signal de contrôle 402 généré par le processeur 311. La génération du signal de contrôle peut selon les implémentations être obtenue en réponse à une manipulation sur l'interface homme machine locale (par exemple la saisie d'un code secret) ou en réponse à la réception d'une commande par l'intermédiaire de l'interface de communication, par exemple une commande en provenance de l'opérateur du réseau électrique.

Selon un exemple de réalisation, le fonctionnement du dispositif de la figure 4 peut comprendre les étapes suivantes:
a) Lorsque le cache doit être ouvert, l'interrupteur 401 est fermé préalablement par génération d'un signal de commande de fermeture par le processeur 311.
b) Le condensateur 303 est déchargé.
c) Le dispositif 100 est mis hors tension. L'interrupteur 401 est prévu pour s'ouvrir automatiquement dans ce cas.
d) Le cache 302 peut alors être ouvert.
e) Le fusible 308 reste intact.
f) Une fois la ou les opérations prévues effectuées, le cache 302 est refermé.
g) Le dispositif 100 est remis sous tension.
h) Le processeur 311 détecte que le fusible est intact.
i) Le condensateur 303 se recharge.
j) Le dispositif est de nouveau protégé contre une ouverture non autorisée du cache.

L'interrupteur 401 est - par exemple - implémenté à l'aide d'un transistor de type MOSFET.

Dans les exemples des figures 3 et 4, le dispositif 100 comporte un processeur. Certains compteurs comportent plusieurs processeurs - par exemple un processeur applicatif et un processeur de métrologie. L'un ou l'autre peuvent remplir la fonction du processeur 311.

Un avantage supplémentaire des exemples de réalisation présentés est qu'un installateur n'a pas forcément à être au courant du fonctionnement du dispositif. En effet, l'installation s'effectue de la même façon que pour un compteur classique.

Dans les exemples ci-dessus, l'exemple d'un compteur électrique a été considéré. Cependant le dispositif 100 peut être un autre type de compteur (gaz, eau...) ou encore tout dispositif comprenant un boîtier muni d'un cache d'ouverture et pour lequel une ouverture doit être détectée.

Selon un mode de réalisation, la détection d'ouverture est mise en œuvre pour plusieurs éléments d'un dispositif. Avantageusement, un seul fusible est utilisé, et plusieurs interrupteurs placés en parallèle, un pour chaque élément dont l'ouverture est à détecter.

Par exemple, à titre non limitatif, dans le cadre d'un compteur électrique, l'ouverture tant du capot que du couvre-bornes peut être détectée indépendamment. Selon une implémentation possible, deux paires de lamelles sont placées en parallèle, et un seul fusible est utilisé. La première paire de lamelles est écartée par la mise en place du couvre-bornes et la seconde par la mise en place du capot. L'ouverture de l'un des deux organes va faire claquer le fusible 304 à l'ouverture du couvre-bornes ou du capot hors tension si le condensateur 303 est chargé.

### LISTE DES SIGNES DE REFERENCE

100 - Dispositif
101 - Boîtier
102 - Cache
103 - Verrou
104 - Affichage
201 - Bornes électriques
202 - Ouverture
301 - Cache
302 - Membre proéminent
303 - Condensateur
304 - Fusible
305 - Lamelles
306 - Source de tension
307 - Résistance
308 - Résistance
309 - Masse
310 - Résistance
311 - Processeur
312 - Interface de communication
313 - Source de tension
401 - Interrupteur
402 - Signal de commande

## Revendications

1. Dispositif (100) comportant :
- un boîtier comportant des composants (201) ;
- un cache (301) configuré pour être positionné sur le boîtier pour limiter l'accès aux composants lorsque le cache est en position fermée ;
- un circuit de charge d'un condensateur (303) configuré pour charger le condensateur lorsque le dispositif est sous tension;
**caractérisé par**
- le condensateur et un fusible (304), le condensateur et le fusible étant dimensionnés pour que le fusible claque lorsque le condensateur se décharge à travers le fusible ;
- un circuit de décharge du condensateur à travers le fusible, ledit circuit de décharge comportant un premier interrupteur (305) coopérant avec une pièce (302) solidaire du cache pour :
bloquer la décharge du condensateur lorsque le cache est en position fermée; et
permettre la décharge du condensateur à travers le fusible lorsque le cache est en position ouverte.

2. Dispositif selon la revendication 1, dans lequel le circuit de décharge est configuré pour relier électriquement le condensateur et le fusible à travers le premier interrupteur, le premier interrupteur comprenant des pièces conductrices (305) configurées pour être en contact électrique lorsque le cache est en position ouverte et pour être écartées par la pièce (302) solidaire du cache lorsque le cache est en position fermée, interrompant ainsi le contact électrique entre les pièces conductrices.

3. Dispositif selon la revendication 2, dans lequel les pièces conductrices comportent deux lamelles métalliques (305).

4. Dispositif selon l'une des revendications précédentes, dans lequel la pièce (302) solidaire du cache est un membre proéminent solidaire du cache.

5. Dispositif selon l'une des revendications précédentes, dans lequel le circuit de charge comporte une source de tension (306) reliée à une première borne du condensateur à travers une résistance (307), une seconde borne du condensateur étant reliée à la masse (309), la source de tension étant configurée pour fournir une tension de charge du condensateur lorsque le dispositif est sous tension.

6. Dispositif selon l'une des revendications précédentes, dans lequel le condensateur est dans un état déchargé avant une première mise sous tension du dispositif.

7. Dispositif selon l'une des revendications précédentes, comportant un second interrupteur (401) commandé par un signal de commande (402), le second interrupteur étant configuré pour permettre le déchargement du condensateur autrement qu'en passant par le fusible.

8. Dispositif selon la revendication 7, dans lequel le second interrupteur est configuré pour court-circuiter le condensateur en réponse au signal de commande.

9. Dispositif selon l'une des revendications 7 ou 8, comportant un processeur (311) configuré pour générer le signal de commande sous contrôle d'un utilisateur autorisé.

10. Dispositif selon l'une des revendications précédentes, le dispositif étant un compteur électrique et les composants comprenant les bornes électriques du compteur.

11. Dispositif selon l'une des revendications précédentes comportant un processeur (311) configuré pour déterminer si le fusible a claqué ou non et dans l'affirmative, générer un signal d'alerte.

12. Dispositif selon l'une des revendications précédentes, dans lequel le fusible est un fusible sérigraphié sur un circuit imprimé du dispositif.

## Patentansprüche

1. Vorrichtung (100), die aufweist:
- ein Gehäuse, das Komponenten (201) aufweist;
- eine Abdeckung (301), die dazu konfiguriert ist, auf dem Gehäuse positioniert zu werden, um den Zugang zu den Komponenten einzuschränken, wenn sich die Abdeckung in geschlossener Position befindet;
- einen Ladekreis eines Kondensators (303), der zum Laden des Kondensators konfiguriert ist, wenn die Vorrichtung unter Spannung steht;
**gekennzeichnet durch**
- den Kondensator und eine Sicherung (304), wobei der Kondensator und die Sicherung so bemessen sind, dass die Sicherung durchbrennt, wenn sich der Kondensator über die Sicherung entlädt;
- einen Kreis zum Entladen des Kondensators über die Sicherung, wobei der Entladekreis einen ersten Unterbrecher (305) aufweist, der mit einem Teil (302) zusammenwirkt, das mit der Abdeckung fest verbunden ist, zum:
Blockieren der Entladung des Kondensators, wenn sich die Abdeckung in der geschlossenen Position befindet; und
Zulassen der Entladung des Kondensators über die Sicherung, wenn sich die Abdeckung in offener Position befindet.

2. Vorrichtung nach Anspruch 1, wobei der Entladekreis zum elektrischen Anschließen des Kondensators und der Sicherung über den ersten Unterbrecher konfiguriert ist, und der erste Unterbrecher leitfähige Teile (305) umfasst, die konfiguriert sind, n elektrischem Kontakt zu stehen, wenn sich die Abdeckung in der offenen Position befindet, und durch das Teil (302), das mit der Abdeckung fest verbunden ist, auseinandergedrückt zu werden, wenn sich die Abdeckung in der geschlossenen Position befindet, wodurch der elektrische Kontakt zwischen den leitfähigen Teilen unterbrochen wird.

3. Vorrichtung nach Anspruch 2, wobei die leitfähigen Teile zwei Metalllamellen (305) aufweisen.

4. Vorrichtung nach einem der vorstehenden Ansprüche, wobei das Teil (302), das mit der Abdeckung fest verbunden ist, ein hervorstehendes Element ist, das mit der Abdeckung fest verbunden ist.

5. Vorrichtung nach einem der vorstehenden Ansprüche, wobei der Ladekreis eine Spannungsquelle (306) aufweist, die über einen Widerstand (307) an eine erste Verbindungsklemme des Kondensators angeschlossen ist, wobei eine zweite Verbindungsklemme des Kondensators mit der Masse (309) verbunden ist, wobei die Spannungsquelle zum Bereitstellen einer Ladespannung des Kondensators konfiguriert ist, wenn die Vorrichtung unter Spannung steht.

6. Vorrichtung nach einem der vorstehenden Ansprüche, wobei sich der Kondensator vor einem ersten Setzen unter Spannung der Vorrichtung in einem entladenen Zustand befindet.

7. Vorrichtung nach einem der vorstehenden Ansprüche, umfassend einen zweiten Unterbrecher (401), der durch ein Steuersignal (402) gesteuert wird, wobei der zweite Unterbrecher zum Zulassen des Entladens des Kondensators auf andere Weise als via die Sicherung konfiguriert ist.

8. Vorrichtung nach Anspruch 7, wobei der zweite Unterbrecher zum Kurzschließen des Kondensators als Reaktion auf das Steuersignal konfiguriert ist.

9. Vorrichtung nach einem der Ansprüche 7 oder 8, die einen Prozessor (311) aufweist, der zum Erzeugen des Steuersignals unter einer Kontrolle eines autorisierten Benutzers konfiguriert ist.

10. Vorrichtung nach einem der vorstehenden Ansprüche, wobei die Vorrichtung ein elektrischer Zähler ist und die Komponenten die elektrischen Verbindungsklemmen des Zählers umfassen.

11. Vorrichtung nach einem der vorstehenden Ansprüche, die einen Prozessor (311) aufweist, der zum Bestimmen, ob die Sicherung durchgebrannt ist oder nicht, und im bejahenden Fall zum Erzeugen eines Warnsignals konfiguriert ist.

12. Vorrichtung nach einem der vorstehenden Ansprüche, wobei die Sicherung eine Sicherung ist, die auf eine Leiterplatte der Vorrichtung siebgedruckt ist.

## Claims

1. A device (100) comprising:
- a housing comprising components (201);
- a cover (301) configured to be positioned on the housing in order to restrict access to the components when the cover is in closed position;
- a charging circuit for a capacitor (303) configured to charge the capacitor when the device is powered up;
**characterized by**
- the capacitor and a fuse (304), the capacitor and the fuse being dimensioned so that the fuse blows when the capacitor discharges through the fuse;
- a discharge circuit for discharging the capacitor through the fuse, said discharge circuit comprising a first switch (305) engaging with a part (302) rigidly connected to the cover in order to:
prevent the discharging of the capacitor when the cover is in closed position; and
allow the capacitor to discharge through the fuse when the cover is in the open position.

2. The device according to claim 1, wherein the discharge circuit is configured to electrically connect the capacitor and the fuse through the first switch, the first switch comprising conductive parts (305) configured to be in electrical contact when the cover is in the open position and to be moved apart by the part (302) rigidly connected to the cover when the cover is in the closed position, thereby breaking the electrical contact between the conductive parts.

3. The device according to claim 2, wherein the conductive parts comprise two metal strips (305).

4. The device according to any of the preceding claims, wherein the part (302) rigidly connected to the cover is a projecting member rigidly connected to the cover.

5. The device according to any of the preceding claims, wherein the charging circuit comprises a voltage source (306) connected to a first terminal of the capacitor through a resistor (307), a second terminal of the capacitor being connected to ground (309), the voltage source being configured to provide a voltage for charging the capacitor when the device is powered up.

6. The device according to any of the preceding claims, wherein the capacitor is in a discharged state prior to the first time the device is powered up.

7. The device according to any of the preceding claims, comprising a second switch (401) controlled by a control signal (402), the second switch being configured to allow the capacitor to be discharged other than via the fuse.

8. The device according to claim 7, wherein the second switch is configured to short-circuit the capacitor in response to the control signal.

9. The device according to any of claims 7 or 8, comprising a processor (311) configured to generate the control signal under the control of an authorized user.

10. The device according to any of the preceding claims, the device being an electric meter and the components comprising the electrical terminals of the meter.

11. The device according to any of the preceding claims, comprising a processor (311) configured to determine whether or not the fuse has blown and, if so, to generate an alert signal.

12. The device according to any of the preceding claims, wherein the fuse is a fuse screen-printed on a printed circuit board of the device.
